# EUROPEAN PATENT APPLICATION

(11) **EP 3 364 464 A1**
(43) Date of publication of application: **22.08.2018**
(21) Application number: 16854907.9
(22) Date of filing: 09.10.2016
(51) Int. Cl.: H01L 31/18

(54) **COMBINED SOLAR CELL EDGE GRINDING MACHINE AND PRIMARY CLEANING MACHINE ANTI-CHIP-BLOCKING SYSTEM**

(30) Priority: 12.10.2015 CN 201520789277 U
(71) Applicant: Guangdong Hanergy Thin-Film Solar Co., Ltd., Heyuan, Guangdong 517000 (CN)
(72) Inventor: SU, Jinghong, Heyuan Guangdong 517000 (CN); BAO, Liqiang, Heyuan Guangdong 517000 (CN); ZHANG, Huizhou, Heyuan Guangdong 517000 (CN); LAI, Wenbo, Heyuan Guangdong 517000 (CN); ZHENG, Jie, Heyuan Guangdong 517000 (CN); NIAN, Zhigang, Heyuan Guangdong 517000 (CN); ZHOU, Jian, Heyuan Guangdong 517000 (CN)
(74) Representative: Casalonga
(86) International application number: PCT/CN2016/101580
(87) International publication number: WO 2017/063528

(57) **Abstract**

Disclosed is a combined solar cell edge grinding machine and primary cleaning machine anti-chip-blocking system, comprising an edge grinding machine (1) and a primary cleaning machine (2). A discharge port of the edge grinding machine (1) is connected to a feeding port of the primary cleaning machine (2) via a transmission line (3). Both the edge grinding machine (1) and the primary cleaning machine (2) are internally provided with a swing sensor (4). The swing sensors (4) comprise a swing holder unit (5) and a base unit (6). The swing holder unit (5) comprises a swing head (11) and a swing holder (9). The upper portion of the swing head (11) is coupled to the swing holder (9) by means of a stainless steel shaft (7). A roller (10) is arranged at the upper portion of the swing head (11). The roller (10) is coupled to the swing head (11) by means of a plastic shaft. A cylindrical magnet is arranged at the lower portion of the swing head (11). The base unit (6) comprises a connecting shaft (4) and a base (15). The lower portion and the upper portion of the connecting shaft (14) are respectively coupled to the base (15) and the swing holder (9) by means of sealing rings (13). A washer and a magnetic switch (12) are placed at the top of the connecting shaft (14). An electric wire at the end portion of the magnetic switch (12) runs through the centre of the washer and the shaft centre of the connecting shaft (14). The device has high accuracy, strongly reliable system operation, and good waterproof properties, and the maintenance thereof is convenient and the cost thereof is low.

## Description

### TECHNICAL FIELD

The present disclosure relates to a field of solar cell technology, and in particular to a combined solar cell edge grinding machine and primary cleaning machine anti-chip-blocking system.

### BACKGROUND

In the field of solar cell production, chip's edging and cleaning are front and back processes, respectively. A cleaning machine and an edge grinding machine each has its own photoelectric sensor, and each has its own software alarm system. If a blocking alarm occurs in the cleaning machine, the cleaning machine sends a warning signal to make the edge grinding machine and a transmission line stop transmitting chips, to prevent a batch of chips from flowing down resulting in these chips being blocked and scrapped. However, due to the fact that the current primary cleaning machine uses photoelectric sensors and the photoelectric sensors have poor waterproof capabilities, miscalculations often occur in actual production. After the primary cleaning machine sends the warning signal, the edge grinding machine and the transmission line do not stop transmitting the chips, and multiple batch chips are blocked and scrapped accordingly.

### SUMMARY

The object of the disclosure is to provide a combined solar cell edge grinding machine and primary cleaning machine anti-chip-blocking system, which has characteristics of high sensing accuracy, strong sensing reliability, good waterproofness, strong system operation stability, convenient maintenance and low cost features.

The disclosure can be realized by the following technical solutions:
The disclosure discloses a combined solar cell edge grinding machine and primary cleaning machine anti-chip-blocking system, which comprises an edge grinding machine and a primary cleaning machine. A discharge outlet of the edge grinding machine and a feed inlet of the primary cleaning machine are connected by a transmission line. Interiors of the edge grinding machine and the primary cleaning machine are both provided with swing sensors. The swing sensor comprises a swing holder unit and a base unit. The swing holder unit includes a swing head and a swing holder. A middle-upper portion of the swing head is connected with the swing holder through a stainless steel shaft. An upper portion of the swing head is provided with a roller. A center of the roller is connected with the swing head through a plastic shaft. A cylindrical magnet is provided inside the lower portion of the swing head, and is cemented and sealed with glue. The cylindrical magnet is provided inside the lower portion of the swing head, and mass of the cylindrical magnet is greater than that of the roller in the upper portion of the swing head. The stainless steel shaft passes through the middle-upper portion of the swing head. Due to the influence of gravity and under the condition of no external force, an end of the swing head having the roller on the upper portion thereof is on top, and an opposite end of the swing head having the cylindrical magnet inside the swing head is below. The base unit includes a connecting shaft and a base. The lower portion of the connecting shaft is connected with the base through two sealing rings. There are two hexagon socket screws fixed on the side surface of the base. The upper portion of the connecting shaft is connected with the swing holder through two sealing rings. There are two hexagon socket screws fixed on the side surface of the swing holder. A through hole is provided in the connecting shaft along the axis thereof. A gasket is disposed on top of the connecting shaft. A magnetic switch is provided on top of the gasket. A wire at a rear end of the magnetic switch just passes through a center of the gasket and the axis of the connecting shaft. An outer diameter of a head of the magnetic switch is larger, so the head cannot pass through the center of the gasket and the axis of the connecting shaft. The head of the magnetic switch can be just embedded in the inside of the swing holder.

By using a swing sensor instead of a conventional photoelectric sensor provided inside the edge grinding machine and the primary cleaning machine, the problem of inaccurate sensing caused by the non-waterproof photoelectric sensor may be effectively overcome, and a hidden trouble caused by a continuous feeding of the edge grinding machine and the transmission line under the failure of a primary cleaning machine may be avoided, ensuring the stability of the system operation. By using the swing sensor in which the swing holder unit and the base unit are in structural cooperation, the entire swing sensor may perform swing induction around the roller. The structure of the entire swing sensor is very simple, and assembly and maintenance are very convenient. The manufacturing cost of the swing sensor is effectively reduced, and thus the swing sensor has broad application prospects.

The positions of the swing sensors are adjustable in interiors of the edge grinding machine and the primary cleaning machine. During use, if the position of the swing sensor in the edge grinding machine is adjusted forward and the position of the swing sensor in the cleaning machine is adjusted backward, the spacing between the two swing sensors is increased, and the alarm protection range is also increased. The alarm time may be set according to the time interval when the solar cell chip passes through two swing sensor.

The cylindrical magnet is disposed inside the lower portion of the swing head. The mass of the cylindrical magnet is greater than that of the roller on the upper portion of the swing head, and the stainless steel shaft passes through the middle-upper portion of the swing head. Due to the influence of gravity and under the condition of no external force, the end of the swing head having the roller on the upper portion thereof is on top, and the end of the swing head having the cylindrical magnet inside the swing head is below. This structure has a strong sensing reliability.

The upper portion of the swing head is provided with the roller. The center of the roller is coupled with the swing head through the plastic shaft. Here, the roller has micro-action and the friction force is extremely small. This structure has high sensing accuracy.

A cylindrical magnet is provided inside the lower portion of the swing head, and is cemented and sealed with glue. This structure has good waterproofness.

The lower portion of the connection shaft is connected with the base through two sealing rings, and two hexagon socket screws are fixed on the side surface of the base; the upper portion of the connection shaft is connected with the swing holder through two sealing rings, and two hexagon socket screws are fixed on the side surface of the swing holder. This structure has good waterproof.

The material of the gasket and the plastic shaft is a thermoplastic plastic, which has a low cost and certain softness, playing a certain buffering effect and having a long service life.

The combined solar cell edge grinding machine and primary cleaning machine anti-chip-blocking system provided by the present disclosure has the following beneficial effects.

Firstly, the sensing accuracy of the system is high. The roller is provided at the upper portion of a swing head. The roller's center is connected with the swing head through the plastic shaft. Here, the roller has a micro-action function and the friction force is extremely small. The structure has high sensing accuracy.

Secondly, the reliability of sensing of the system is strong. The cylindrical magnet is disposed inside a lower portion of the swing head. The mass of the cylindrical magnet is greater than that of the upper portion of the swing head, and the stainless steel shaft passes through the middle-upper portion of the swing head. Due to the influence of gravity and under the condition of no external force, the end of the swing head having the roller on the upper portion thereof is on top, and the end of the swing head having the cylindrical magnet inside the swing head is below. This structure has strong sensing reliability.

Thirdly, waterproofness of the system is good. The cylindrical magnet is provided inside the lower portion of the swing head, and is cemented and sealed with glue. This structure has good waterproofness; the lower portion of the connecting shaft is connected with the base through two sealing rings, and two hexagon socket screws are fixed on the side surface of the base; the upper portion of the connection shaft is connected with the swing holder through two sealing rings, and two hexagon socket screws are fixed on the side surface of the swing holder. This structure has good waterproofness.

Fourthly, the stability of the operation of the system is strong. By using a swing sensor instead of a conventional photoelectric sensor provided inside the edge grinding machine and the primary cleaning machine, the problem of inaccurate sensing caused by the non-waterproof photoelectric sensor is effectively overcome, and a hidden trouble caused by a continuous feeding of the edge grinding machine and the transmission line under the failure of a primary cleaning machine is avoided, ensuring the stability of the operation of the system.

Fifthly, the maintenance of the system is convenient. By using the swing sensor in which the swing holder unit and the base unit are in structural cooperation, the entire swing sensor may perform swing induction around the roller. The structure of the entire swing sensor is very simple, and assembly and maintenance are very convenient.

Sixthly, the cost of the system is low. By using the swing sensor in which the swing holder unit and the base unit are in structural cooperation, the entire swing sensor may perform swing induction around the roller. The structure of the entire swing sensor is very simple and the material cost is low, thereby effectively reducing the manufacturing cost of the swing sensor, and having broad application prospects.

### BRIEF DESCRIPTION OF THE DRAWINGS

Fig. 1 is a schematic composition diagram of a combined solar cell edge grinding machine and primary cleaning machine anti-chip-blocking system according to the present disclosure (the number of the swing sensors is two);
Fig. 2 is a schematic structure diagram of a combined solar cell edge grinding machine and primary cleaning machine anti-chip-blocking system according to the present disclosure (the number of the swing sensors is four);
Fig. 3 is a schematic structure diagram of a combined solar cell edge grinding machine and primary cleaning machine anti-chip-blocking system according to the present disclosure (the number of the swing sensors is eight);
Fig. 4 is a perspective view of a structure of a swing sensor of a combined solar cell edge grinding machine and primary cleaning machine anti-chip-blocking system according to the present disclosure;
Fig. 5 is a perspective view of a structure of a swing holder unit of a combined solar cell edge grinding machine and primary cleaning machine anti-chip-blocking system according to the present disclosure; and
Fig. 6 is a perspective view of a structure of a base unit of a combined solar cell edge grinding machine and primary cleaning machine anti-chip-blocking system according to the present disclosure.

Reference numbers in the drawings include: 1, edge grinding machine; 2, primary cleaning machine; 3, transmission line; 4, swing sensor; 5, swing holder unit; 6, base unit; 7, stainless steel shaft; 9, swing holder; 10, roller; 11, swing head; 12, magnetic switch; 13, sealing ring; 14, connecting shaft; and 15, base.

### DETAILED DESCRIPTION

In order to enable those skilled in the art to better understand the technical solutions of the present disclosure, the products of the present disclosure will be further described in detail below in conjunction with the embodiments and the accompanying drawings.

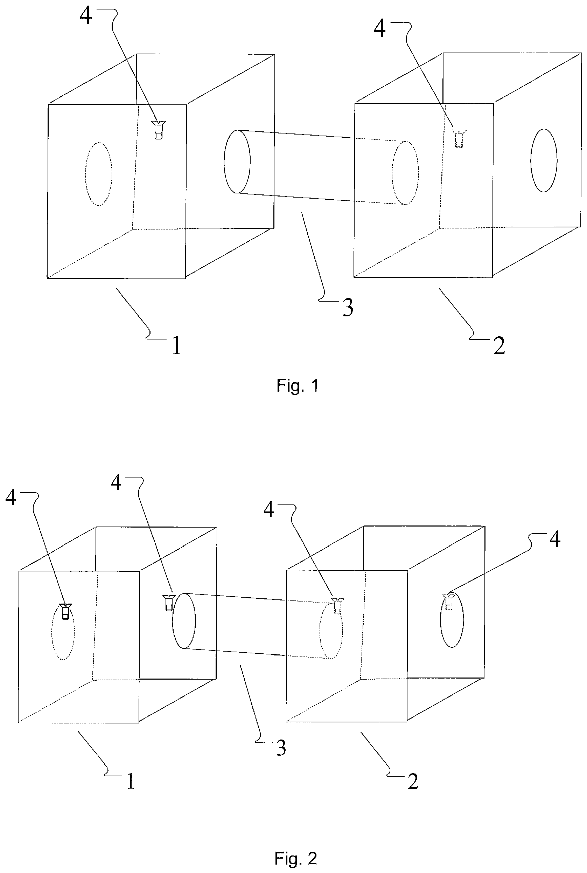

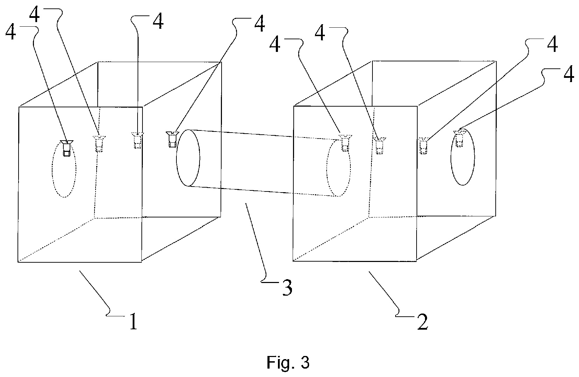

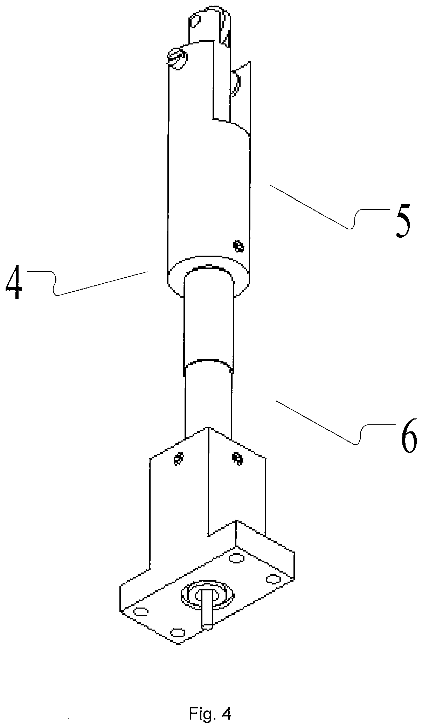

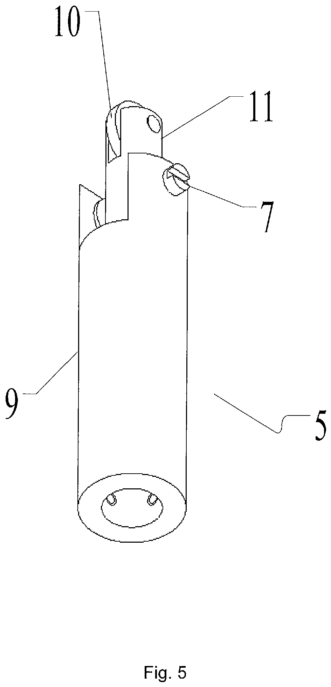

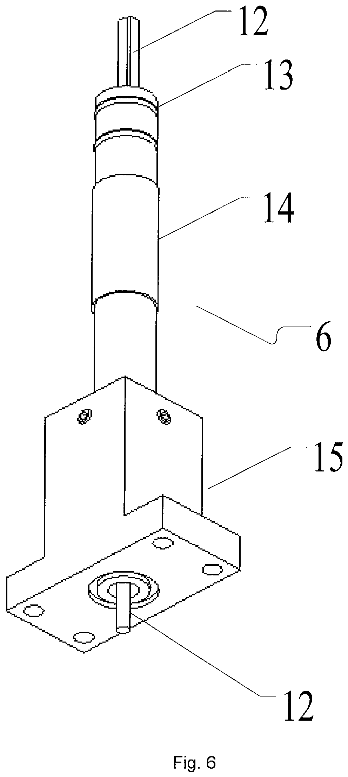

As shown in Figs. 1-6, the present disclosure disclose a combined solar cell edge grinding machine and primary cleaning machine anti-chip-blocking system, which includes an edge grinding machine 1 and a primary cleaning machine 2. A discharge outlet of the edge grinding machine 1 and a feed inlet of the primary cleaning machine 2 are connected through a transmission line 3. The edge grinding machine 1 and the primary cleaning machine 2 each is internally provided with swing sensors 4. Each swing sensor 4 includes a swing holder unit 5 and a base unit 6. The swing holder unit 5 includes a swing head 11 and a swing holder 9. An upper portion of the swing head 11 is coupled to the swing holder 9 through a stainless steel shaft 7. A roller 10 is provided at an upper end of the swing head 11. A center of the roller 10 is coupled with the swing head 11 through a plastic shaft. A lower portion of the swing head 11 is provided with a cylindrical magnet 18. The base unit 6 includes a connecting shaft 14 and a base 15. A lower portion of the connecting shaft 14 is connected with the base 15 through a sealing ring 19. An upper portion of the connecting shaft 14 is connected with the swing holder 9 through a sealing ring 13. A through hole is provided in the connecting shaft 14 along its axis. A gasket 17 is disposed on top of the connecting shaft. A magnetic switch 12 is provided on top of the gasket 17. A wire at a rear end of the magnetic switch 12 passes through a center of the gasket and the axis of the connecting shaft 14. The positions of the swing sensors 4 are adjustable in interiors of the edge grinding machine 1 and the primary cleaning machine 2, respectively. The number of the swing sensors 4 is 2∼8. Fig. 1 shows an embodiment in which the number of swing sensors is two. Fig. 2 shows an embodiment in which the number of swing sensors 4 is four. Fig. 3 shows an embodiment in which the number of swing sensors 4 is eight. In Figs. 1 to 3, all of the swing sensors 4 are set on the same straight line to ensure the accuracy of the sensing.

The foregoing descriptions are merely some better embodiments of the present disclosure and are not intended to limit the disclosure in any form. Those of ordinary skill in the art may smoothly implement the disclosure as shown in the accompanying drawings of the specification and the described above. However, those skilled in the art can make use of the above-disclosed technical contents to make some equivalent changes such as modifications, decorations and evolutions, without departing from the scope of the technical solution of the present disclosure, which are equivalent embodiments of the present disclosure. Meanwhile, any modification, decoration and evolution of any equivalent changes made from the above embodiments based on the essential technologies of the present disclosure are still within the protection scope of the technical solutions of the present disclosure.

## Claims

1. A combined solar cell edge grinding machine and primary cleaning machine anti-chip-blocking system, comprising an edge grinding machine (1) and a primary cleaning machine (2), a discharge outlet of the edge grinding machine (1) and a feed inlet of the primary cleaning machine (2) being connected through a transmission line (3), **characterized in that**, the edge grinding machine (1) and the primary cleaning machine (2) each is internally provided with swing sensors (4), and each swing sensor (4) comprises a swing holder unit (5) and a base unit (6); the swing holder unit (5) comprises a swing head (11) and a swing holder (9), and an upper portion of the swing head (11) is connected with the swing holder (9) through a stainless steel shaft (7); a roller (10) is provided at an upper end of the swing head (11); a center of the roller (10) is coupled with the swing head (11) through a plastic shaft; a cylindrical magnet is arranged at a lower portion of the swing head (11); the base unit (6) comprises a connecting shaft (14) and a base (15); a lower portion of the connecting shaft (14) is coupled to the base (15) through a sealing ring (13); a upper portion of the connecting shaft (14) is connected with the swing holder (9) through a sealing ring (13); a through hole is provided in the connecting shaft (14) along an axis of the connecting shaft (14), a gasket is placed on top of the connecting shaft, a magnetic switch (12) is provided on top of the gasket, and a wire at a rear end of the magnetic switch (12) passes through a center of the gasket and the axis of the connecting shaft (14).

2. The combined solar cell edge grinding machine and primary cleaning machine anti-chip-blocking system according to claim 1, **characterized in that** positions of swing sensors (4) are adjustable in interiors of the edge grinding machine (1) and the primary cleaning machine (2), respectively.

3. The combined solar cell edge grinding machine and primary cleaning machine anti-chip-blocking system according to claim 1, **characterized in that** the number of the swing sensors (4) is 2∼8.
